(19) Europäisches Patentamt
European Patent Office
Office européen des brevets

(11) Veröffentlichungsnummer: **0 510 477 A1**

(12) EUROPÄISCHE PATENTANMELDUNG

(21) Anmeldenummer: **92106348.3**

(22) Anmeldetag: **13.04.92**

(51) Int. Cl.5: **C08L 81/02**, C08K 5/3415, C08K 3/26

(30) Priorität: **26.04.91 DE 4113694**

(43) Veröffentlichungstag der Anmeldung: **28.10.92 Patentblatt 92/44**

(84) Benannte Vertragsstaaten: **BE DE FR GB IT**

(71) Anmelder: **BAYER AG**

**W-5090 Leverkusen 1 Bayerwerk(DE)**

(72) Erfinder: **Köhler, Burkhard, Dr.**
**Mündelheimer Strasse 94**
**W-4150 Krefeld 11(DE)**
Erfinder: **Imai, Seisaku, Dr.**
**Nietzschestrasse 8**
**W-5090 Leverkusen 1(DE)**
Erfinder: **Jeschke, Kurt**
**Ansbacher Strasse 24**
**W-4000 Düsseldorf 13(DE)**

(54) **Mischungen aus Polyarylensulfiden, Dolomit und Maleinimiden.**

(57) Die Erfindung betrifft Mischungen aus Polyarylensulfiden, Maleinimiden und Dolomit. Die Mischungen zeichnen sich durch gute mechanischen Eigenschaften aus und eignen sich besonders zur Herstellung von z.B. mit Metallen bedampfbaren Formkörpern.

EP 0 510 477 A1

Die Erfindung betrifft Mischungen aus Polyarylensulfiden, Maleinimiden und Dolomit. Die Mischungen zeichnen sich durch gute mechanische Eigenschaften aus und eignen sich besonders zur Herstellung von z.B. mit Metallen bedampfbaren Formkörpern.

Polyarylensulfide (PAS) sind bekannt (z.B. US-A 3 354 129, EP-A 171 021). Sie sind inerte, hochtemperaturbeständige Thermoplaste, die einen hohen Füllgrad, z.B. mit Glasfasern und/oder anderen anorganischen Füllstoffen erlauben. Der Einsatz dieser Polymeren, insbesondere des Polyphenylensulfids (PPS), nimmt in Bereichen zu, die bislang Duroplasten vorbehalten waren.

PAS hat mechanische Eigenschaften, die für einige Anwendungen z.B. im Spritzgußbereich unzureichend sind. Insbesondere sind Biege- und Zugfestigkeit, Randfaserdehnung, Schlagzähigkeit und Elastizitätsmodul für die Praxis häufig nicht ausreichend. Es hat sich daher als Vorteil erwiesen, PAS z.B. durch Abmischung mit anderen Thermoplasten, z.B. mit Polycarbonaten in den genannten Eigenschaften zu verbessern (z.B. JP-A 51 59952, EP-A 104 543, US-A 4 021 596).

Für bestimmte Anwendungsgebiete ist das Eigenschaftsprofil derartiger Abmischungen jedoch nicht immer ganz befriedigend.

Besonders hohe Anfordrungen werden an metallbedampfbare PAS-Mischungen gestellt. Sie müssen eine gute Oberfläche aufweisen. Saure Ausgasungen können durch basische Füllstoffe, z.B. Dolomit, auch bei höheren Temperaturen verhindert werden, so daß durch Ausgasungen keine Beläge auf der Metallschicht entstehen. Solche dolomithaltigen, glasfaserfreien Mischungen zeigen eine geringe Zähigkeit und Randfaserdehnung. Es bestand die Aufgabe, dolomithaltige Compounds mit guter Zähigkeit und hoher Randfaserdehnung herzustellen.

Es wurde nun gefunden, daß Abmischungen von Polyarylensulfiden (PAS), vorzugsweise Polyphenylensulfid (PPS) mit Dolomit und Maleinimiden, vorzugsweise ausgewählten Tetramaleinimiden, sich durch eine deutlich verbesserte Zähigkeit auszeichnen. Die Zunahme der Zähigkeit liegt deutlich über der Zähigkeitszunahme in Gegenwart von Glasfasern oder anderen Füllstoffen.

Gegenstand der Erfindung sind daher Mischungen aus

A) 99,9 bis 20 Gew.-%, bevorzugt

90 bis 20 Gew.-% Polyarylensulfiden, bevorzugt PPS,

B) 0,1 bis 40 Gew.-%, bevorzugt

0,5 bis 5 Gew.-% eines Maleinimids der Formel (I) und/oder (II), vorzugsweise der Formel (II)

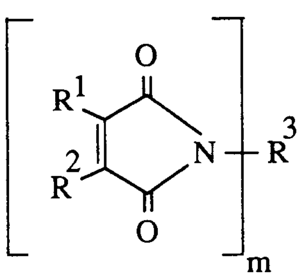

(I),

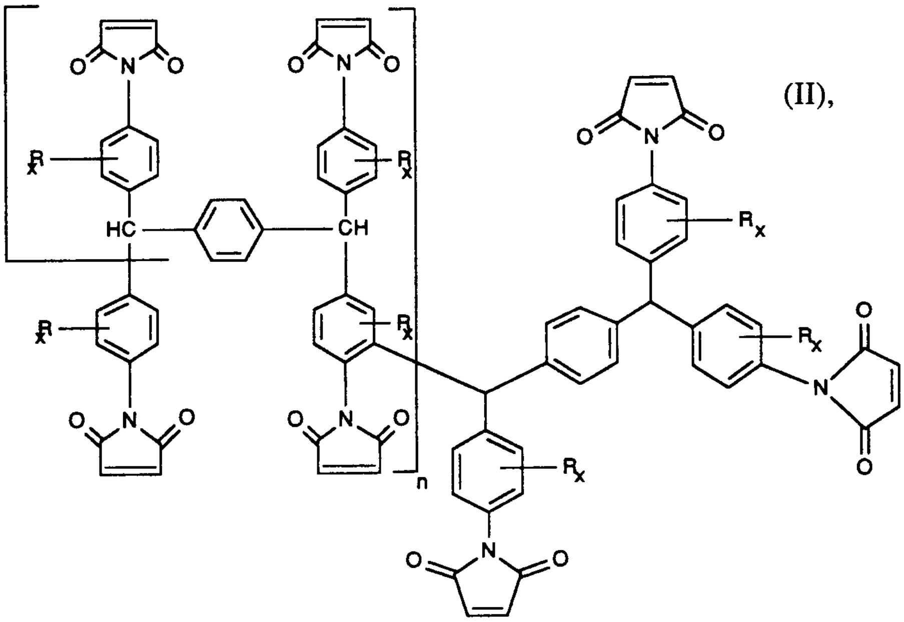

(II),

wobei

$R^1$ und $R^2$ gleich oder verschieden sein können und Wasserstoff, $C_1$-$C_{22}$-Alkyl, bevorzugt Methyl, $C_6$-$C_{14}$-Aryl, bevorzugt Phenyl oder $C_7$-$C_{22}$-Aralkyl oder $C_7$-$C_{22}$-Alkylaryl, besonders bevorzugt Wasserstoff bedeuten,

$R^3$ ein m-valenter vorzugsweise divalenter Rest, mit 1 bis 38 aliphatischen C-Atomen ist, die gegebenenfalls auch in Ringen angeordnet sein können und/oder divalente aromatische Reste mit 6 bis 24-C-Atomen sind und/oder divalente aromatisch-aliphatische und/oder aliphatisch-aromatische Reste mit 7 bis 40 C-Atomen sind, wobei gegebenenfalls zwei oder mehr aromatische, aliphatische Ringe durch eine chemische Bindung, ein Sauerstoffatom, ein Schwefelatom, eine Carbonylgruppe und/oder eine Sulfongruppe verknüpft sein können.

m für eine Zahl von 2-5, bevorzugt für 2, steht,

R gleich oder verschieden sein können und Wasserstoff, $C_1$-$C_{22}$-Alkyl, bevorzugt Methyl, $C_6$-$C_{14}$-Aryl, bevorzugt Phenyl oder $C_1$-$C_{22}$-Aralkyl oder $C_7$-$C_{22}$-Alkylaryl, besonders bevorzugt Wasserstoff oder Methyl, bedeuten,

x für die Zahl 1, 2, 3 oder 4, bevorzugt für 1, steht,

n für eine Zahl von 0 bis 10, bevorzugt für 0, steht,

mit der Maßgabe, daß für (n = 1) die freien Valenzen der Formel (II) mit Wasserstoff abgesättigt sind, und bis zu 1/4 der Maleinimidstrukturen der Formeln (I) und/oder (II) durch nicht cyclisierte Maleinamidsäurestrukturen ersetzt sein können, und

C) 5 bis 79,9 Gew.-%, bevorzugt
9,9 bis 79,9 Gew.-% Dolomit.

Die Polyarylensulfide sind vorzugsweise linear und ohne Sulfongruppen. Besonders bevorzugt ist Poly-p-phenylensulfid.

Beispiele für erfindungsgemäße Stoffe der Formel (I) sind 1,6-Bis-(maleinimido)-hexan, 1,4-Bis-(maleinimido)-cyclohexan, 1,4-Bis-(maleinimido)-benzol, 4,4'-Bis-(maleinimido)-biphenyl, Bis-(4-maleinimidophenyl)-methan, 2,2-Bis-(4-maleinimidophenyl)-propan,1,3-Bis-(maleinimido)-cyclohexan, 1,5-Bis-(maleinimido)-naphthalin, 1,3-Bis-(maleinimido)-benzol, bis-(maleinimido)-methan, 1,2-Bis-(maleinimido)-ethan, Di-(4-maleinimidophenyl)sulfon, Di-(3-maleinimidophenyl)-sulfon, 4,4'-bis-(maleinimido)-benzophenon, 3,3'-Bis-(maleinimido)-benzophenon, 4,4'-Bis-(maleinimido)-diphenylether, 4,4'-Bis-(maleinimido)-diphenylsulfid usw.

Ein Beispiel für erfindungsgemäße Stoffe der Formel (II) ist das Polyimid MP-2000 X® (Mitsubishi Petrochemical Co.).

Dolomite sind Magsium-Carbonat-Doppelsalze, die in der Natur als Mineral auftreten.

Die erfindungsgemäßen Maleinimide können aus Maleinsäureanhydrid und Amin, z.B. GB-A 1 137 592, hergestellt werden.

Als weitere Zusatzstoffe können z.B. Polyethylenwachse, Ester von Montansäuren (E-Wachse), Ruß, Graphit oder Kohle eingesetzt werden. Als weitere übliche Zusatzstoffe können ferner Pigmente, Fließhilfsmittel, Nucleierungsmittel, Stabilisatoren usw. eingesetzt werden.

Die erfindungsgemäßen Mischungen können auf übliche Art und Weise durch Extrusion hergestellt werden.

Sie können auf übliche Weise zu Formteilen, Halbzeug Fasern, Folien, Profilen, Leiterplatten usw. verarbeitet werden. Die erfindungsgemäßen Mischungen können generell in vorteilhafter Weise dort eingesetzt werden, wo geringe saure Ausgasungen und hohe Zähigkeit von Wichtigkeit sind.

Ein weiterer Gegenstand der Erfindung ist die Verwendung der erfindungsgemäßen Mischungen zur Herstellung von metallbedampfbaren PAS-Mischungen, bevorzugt zur Herstellung von aluminumbedampften Reflektoren für Leuchten und Lampen. Reflektoren aus den erfindungsgemäßen Mischungen zeichnen sich durch eine für mineralgefüllte PAS-Mischungen ungewöhnliche Zähigkeit aus.

Beispiele

Die Herstellung der erfindungsgemäßen Mischungen erfolgte auf einem Doppelwellenextruder ZSK 32 von Werner und Pfleiderer bei 320 °C.

Das verwendete PPS wies eine Schmelzviskosität von 65 PA.s (306 °C), Schubspannung = 1000 $s^{-1}$ auf und wurde nach EP-A 171 021 hergestellt.

Die Mischungen wurden granuliert und zu Prüfstäben (z.B. der Maße 80 x 10 x 4 mm) verspritzt. Diese wurden hinsichtlich Schlagzähigkeit $a_n$ (reversed notched ISO 180) untersucht.

Vergleichsbeispiel 1

Gemischt wurden 39,5 Gew.-% PPS, 0,5 Gew.-% E-Wachs und 60 Gew.-% gemahlener Dolomit. (E-Wachs = übliches Entformungswachs wie Montansäureester).
Die Schlagzähigkeit beträgt 7 $kJ/m^2$.

Beispiel 1

Gemischt wurden 38,5 Gew.-% PPS, 1 Gew.-% 4,4'-Bis(maleinimido)diphenylmethan, 0,5 Gew.-% E-Wachs und 60 Gew.-% gemahlener Dolomit.
Die Schlagzähigkeit beträgt 14 $kJ/m^2$.

Beispiel 2 Gemischt wurden 38,5 Gew.-% PPS, 1 Gew.-% des Polymaleinimids MP-2000 X® der Mitsubishi Petrochemical Co, eines Polymaleinimids der Formel II mit R = Methyl.
Die Schlagzähigkeit beträgt 21 $kJ/m^2$.

Die Zähgkeit der Dolomit-haltigen Compounds wird durch Zugabe von 4,4'-Bis(maleinimido)-diphenylmethan verdoppelt und durch MP-2000 X® verdreifacht.

Vergleichsbeispiel 2a

Gemischt wurden 60 Gew.-% PPS und 40 Gew.-% Glasfaser CS 7916® der Fa. Bayer.
Die Schlagzähigkeit beträgt 30 $kJ/m^2$.

Vergleichsbeispiel 2b

Gemischt wurden 59 Gew.-% PPS und 40 Gew.-% Glasfaser CS 7916® der Fa. Bayer.
Die Schlagzähigkeit beträgt 48 $kJ/m^2$.

Vergleichsbeispiel 2c

Gemischt wurden 59 Gew.-% PPS, 40 Gew.-% Glasfaser CS 7916® und 1 Gew.-% MP-2000 X®.
Die Schlagzähigkeit beträgt 49 $kJ/m^2$.

In Glasfaser-haltigen Compounds bewirken 4,4'-Bis(maleinimido)diphenylmethan und MP-2000 X® nur eine Verbesserung der Zähigkeit um den Faktor 1,6-1,7.

Vergleichsbeispiel 3a

Gemischt wurden 40 Gew.-% PPS, 40 Gew.-% Glimmer und 20 Gew.-% CS 7916®. Die Schlagzähigkeit beträgt 11 kJ/m$^2$.

Vergleichsbeispiel 3b

Gemischt wurden 39 Gew.-% PPS, 40 Gew.-% Glimmer, 20 Gew.-% CS 7916® und 1 Gew.-%, 4,4-Bis-(Maleinimid)diphenylmethan. Die Schlagzähigkeit beträgt 13,6 kJ/m$^2$.

Daraus folgt, daß die Zähigkeitsverbesserung durch Maleinimide bei Dolomithaltigen Compounds besonders deutlich ist, was umso überraschender ist, da unmodifizierte Dolomit-haltige Compounds besonders schlechte Zähigkeitswerte aufweisen, wobei durch Maleinimid-Zusatz die Zähigkeit über das Niveau von Glimmer-gefüllten Compounds angehoben wird. Die Mischungen der Beispiele 1 oder 2, vorzugsweise des Beispiels 2, lassen sich zu Reflektoren verarbeiten, die besonders im Automobilbau eingesetzt werden können, wobei das verbesserte Zähigkeitsniveau besonders wünschenswert ist.

**Patentansprüche**

**1.** Mischungen aus

A) 99,9 bis 20 Gew.-% Polyarylensulfiden,

B) 0,1 bis 40 Gew.-%

eines Maleinimids der Formel (I) und/oder (II), vorzugsweise der Formel (II),

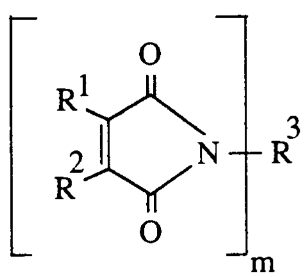

(I),

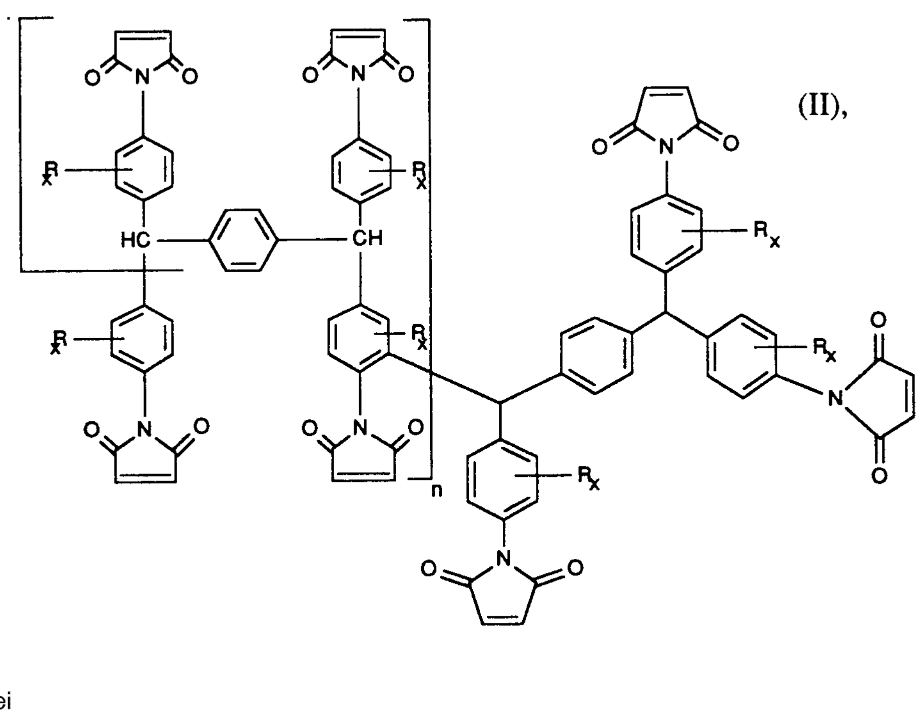

(II),

wobei

R$^1$ und R$^2$ gleich oder verschieden sein können und Wasserstoff, $C_1$-$C_{22}$-Alkyl, $C_6$-$C_{14}$-Aryl, oder $C_7$-$C_{22}$-Aralkyl oder $C_7$-$C_{22}$-Alkylaryl bedeuten,

$R^3$ ein m-valenter vorzugsweise divalenter Rest, mit 1 bis 38 aliphatischen C-Atomen ist, die gegebenenfalls auch in Ringen angeordnet sein können und/oder divalente aromatische Reste mit 6 bis 24-C-Atomen sind und/oder divalente aromatisch-aliphatische und/oder aliphatisch-aromatische Reste mit 7 bis 40 C-Atomen sind, wobei gegebenenfalls zwei oder mehr aromatische, aliphatische Ringe durch eine chemische Bindung, ein Sauerstoffatom, ein Schwefelatom, eine Carbonylgruppe und/oder eine Sulfongruppe verknüpft sein können.

m für eine Zahl von 2-5 steht,

R gleich oder verschieden sein können und Wasserstoff, $C_1$-$C_{22}$-Alkyl, $C_6$-$C_{14}$-Aryl, oder $C_1$-$C_{22}$-Aralkyl oder $C_7$-$C_{22}$-Alkylaryl bedeuten,

x für die Zahl 1, 2, 3 oder 4 steht,

n für eine Zahl von 0 bis 10 steht,

mit der Maßgabe, daß für (n = 1) die freien Valenzen mit Wasserstoff (H) abgesättigt sind und

C) 5 bis 79,9 Gew.-% Dolomit.

**2.** Verwendung von Mischungen nach Anspruch 1 zur Herstellung geformter Körper.

**3.** Verwendung von Mischungen nach Anspruch 1 zur Herstellung von metallbedampften Gegenständen.

**4.** Verwendung von Mischungen nach Anspruch 1 zur Herstellung von Leiterplatten.

Europäisches Patentamt

# EUROPÄISCHER RECHERCHENBERICHT

Nummer der Anmeldung

EP 92 10 6348

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | EP-A-0 275 991 (DAINIPPON INK AND CHEMICALS)<br>* Seite 15, Zeile 33 *<br>* Seite 6, Zeile 33 - Seite 7, Zeile 18; Ansprüche 1,7,11,14,15,17,18 *<br>& JP-A-63 205 357 (DAINIPPON INK AND CHEMICALS)<br>--- | 1-4 | C08L81/02<br>C08K5/3415<br>C08K3/26 |
| Y | WORLD PATENTS INDEX LATEST<br>Derwent Publications Ltd., London, GB;<br>AN 88-17962/03<br>& JP-A-62 280 258 (DAINIPPON INK AND CHEMICALS)<br>* Zusammenfassung *<br>--- | 1-4 | |
| A | EP-A-0 396 935 (BAYER AG)<br>* Seite 2, Zeile 26 - Zeile 34; Ansprüche 1,2 *<br>--- | 1,2 | |
| P,A | EP-A-0 459 229 (BAYER AG)<br>* Ansprüche; Beispiele 2-6 *<br>----- | 1-3 | |
| | | | **RECHERCHIERTE SACHGEBIETE (Int. Cl.5 )** |
| | | | C08L<br>C08K |

Der vorliegende Recherchenbericht wurde für alle Patentansprüche erstellt

| Recherchenort | Abschlußdatum der Recherche | Prüfer |
|---|---|---|
| DEN HAAG | 08 JULI 1992 | KLIER E.K. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)